# EUROPEAN PATENT APPLICATION

(11) **EP 3 154 091 A1**
(43) Date of publication of application: **12.04.2017**
(21) Application number: 15188721.3
(22) Date of filing: 07.10.2015
(51) Int. Cl.: H01L 29/08, H01L 29/739, H01L 29/06, H01L 29/36

(54) **REVERSE-CONDUCTING SEMICONDUCTOR DEVICE**

(71) Applicant: ABB Technology AG, 8050 Zürich (CH)
(72) Inventor: BAUER, Friedhelm, 6714 Semione (CH)
(74) Representative: ABB Patent Attorneys

(57) **Abstract**

A reverse-conducting insulated gate bipolar transistor having a first main electrode (8) on a first main side (10) and a second main electrode (80) on a second main side (12) is provided, wherein on the second main side at least one anode layer (5) of a second conductivity type alternates with at least one anode short layer (6) of a first conductivity type. A drift layer (1) of the first conductivity type having a low doping concentration comprises a first drift layer section (14) towards the first main side (10) and a second drift section (16) towards the second main side (12). A field stop layer (4) is arranged between the first and second drift layer section (14, 16) above the at least one anode layer (5), which field stop layer (4) has a thickness of at most 3 µm and a higher doping concentration than the drift layer (1).

## Description

### Technical Field

The invention relates to the field of power electronics and more particularly to a reverse-conducting semiconductor device according to the preamble of claim 1.

### Background Art

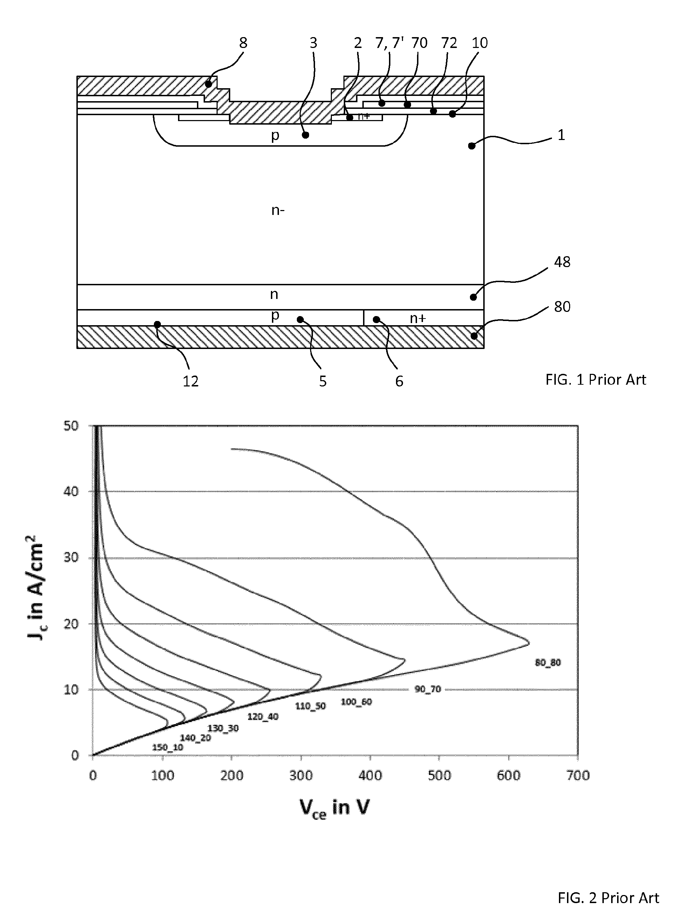

In US 2008/0135871 A1 a reverse-conducting insulated gate bipolar transistor (RC-IGBT) is shown, which comprises within one wafer an insulated gate bipolar transistor with a built-in freewheeling diode. As shown in FIG 1, such a reverse-conducting semiconductor device comprises an n- type drift layer 1 with a first main side 10, which is the emitter side of the integrated IGBT, and a second main side 12, which is the collector side of the IGBT and which lies opposite the emitter side. A p type base layer 3 is arranged on the first main side 10. Embedded into the base layer 3, an n type source layer 2 with a higher doping concentration than the drift layer 1 is arranged. Source layer and base layer 2, 3 contact a first main electrode 8.

A gate electrode 7 in form of a planar gate electrode 7' is arranged on the first main side 10. It comprises an electrically conductive gate layer 70, which is insulated from the base, source and drift layer 3, 2, 1 and also from the first main electrode 8 by an insulating layer 72.

On the second main side 12, an n doped buffer layer 48 is arranged on the drift layer 1. The buffer layer 4 contacts on the side opposite to the drift layer 1 n type anode short layers 6 and p type anode layers 5, which are arranged alternately in a plane parallel to the second main side 12. The buffer layer 48 has a higher doping than the drift layer 1 and the anode short layer 6 an even higher doping concentration than the buffer layer 48. Exemplarily, the buffer layer has a thickness of up to 5 to 30 µm and a doping concentration of 5 * 10¹⁵ cm⁻³ to 1 * 10¹⁷ cm⁻³.

A second main electrode 80 is arranged on the second main side 12 and is in direct electrical contact to the anode short layers 6 and the anode layers 5.

In such a reverse-conducting semiconductor device a freewheeling diode (FWD) is formed between the second main electrode 80, part of which forms a cathode electrode in the diode, the n anode short layer 6, which forms a cathode region in the diode, the drift layer 1, part of which forms the diode base layer, the p base layer 3, part of which forms an anode region in the diode and the first main electrode 8, which forms an anode electrode in the diode.

An insulated gate bipolar transistor (IGBT) is formed between the second main electrode 80, part of which forms the collector electrode in the IGBT, the p type anode layer 5, which forms a collector layer in the IGBT, the drift layer 1, part of which forms the IGBT base layer, the p base layer layer 3, part of which forms a p-base region in the IGBT, the n source layer 2, which forms a n type source region in the IGBT, and the first main electrode 8, which forms an emitter electrode in the IGBT. During on-state of the IGBT a channel is formed between the emitter electrode, the source layer 2 and the p-base layer 3 towards the n-drift layer 1.

Such prior art IGBTs with reverse conduction capability have been attracting attention since several years because of the features they can offer for a number of power electronic applications. The integration of an IGBT and a free-wheeling diode on one die reduces the die size (two versus one die) and allows to increase the power density. However, an anode-short effect occurring at the p-collector layer results in severe current snapback behavior in the IGBT on-state regime at small to medium current densities.

Such conventional RC-IGBTs alleviate the snapback problem by increasing the width of the p-collector layers to several hundred micrometers. However, it has been observed that the strong mismatch in cell dimensions on the first and second main side 10, 12 may result in a decrease of the SOA of the freewheeling diodes leading to hole current filamentation during the reverse recovery process. FIG 2 shows the snap back effect for 400 K on-state mode for a 3.3 kV RC-IGBT. The buffer layer 48 used for FIG 2 has a double diffused profile with a shallow first buffer region of 2 µm and a maximum doping concentration of 2*10¹⁶ cm⁻³ and a deep second buffer region of 25 µm and a maximum doping concentration of 1*10¹⁵ cm⁻³.

In a prior art IGBT (i.e. without n anode short layers), the p-anode-to-n-buffer junction is forward biased when the device is conducting. Accordingly, there is a drop of the electrical potential across the remaining depletion region of this junction of the order of a few tens of a Volt. This voltage drop must develop across the p-anode-to-n-buffer junction in order to cause strong injection of holes into the n-drift layer 1. This happens in a conventional IGBT because all electrons from the emitter electrode inevitably have to enter the p-anode layer.

However, the situation changes when there are n-doped islands/n-short layers 6 present alternating with the p-anode layer 5 as is the case in FIG 1. Depending on the lateral conductivity of the n-doped regions in front of the p-anode (in particular the n-doped buffer layer 48), a more or less substantial amount of electrons (from the cathode) may flow past the p-anode layer 6 in the n-buffer layer 48 and reach the second main electrode 80 via the highly doped n-short layers 5. Thus, these electrons will not contribute to the injection of holes from the p-anode layer 5. In other words, the p-anode layer 5 suffers strongly reduced injection efficiency. This anode-short effect can even inhibit current conduction in the IGBT if the lateral width of the p-anode layer 5 is small and the conductivity of the n-buffer layer 48 is high for electrons.

For a set of IGBT geometries as shown in in FIG 1, p-anode layer and n-short layer stripe widths are varied. In FIG 2, the sum of widths of a p-anode layer and an n-short layer stripe is kept to 160 µm. The widths of the p anode stripes is varied from 150 µm (first number in the figure) to 80 µm, while the stripe widths of the n -short layers is varied from 10 µm to 80 µm (second number in the figure). The snapback voltage ranges from 100 to 600 V with a corresponding snapback current density from 5 to 15 A/cm². These results point out that wide p-anode layer (hundreds of micrometers) must be used in order to suppress the pronounced snapback effect shown in FIG 2. The unsatisfactory design compromise for these conventional RC-IGBT geometries is closely related to the comparatively high doping concentration and the thickness of the conventional, deep diffused n-buffer layer 48. Electrons find a broad, highly conductive channel to flow past the p-anode layer 5. Correspondingly, a high electron current density is needed in this layer to reach the junction bias of approximately 0.7 V required to cause injection of minority carriers (holes) into the n-buffer/n-drift layer 48, 1 in a silicon device.

In US 8212283 B2 a prior art reverse-conducting insulated gate bipolar transistor (RC-IGBT) in form of a Bi-mode Insulated Gate Transistor (BIGT) which comprises a large pilot IGBT region (having a large pilot p doped anode layer) and a mixed part surrounding the pilot anode layer in a plane parallel to the second main side 12 with alternating IGBT and diode regions (i.e. having alternatingly smaller p doped anode layers and n doped anode short layers. US 8212283 B2 shall be incorporated by reference for the design of a BIGT.

Such prior art BIGTs solve the snapback problematic by introducing a large area pilot-IGBT section and an RC-IGBT section with comparatively small dimensions of the p-collector width alternating with n-short layers. The pilot-IGBT basically behaves as a normal IGBT and has no reverse conduction capability; the RC-IGBT section features p-collector layers 5 which are comparatively strongly shorted providing enough n doped cathode area for the FWD section. In order to ignite current conduction in the RC-IGBT section originating from the pilot-IGBT, the p-collector pattern intruding from the pilot-IGBT into the RC-IGBT section is of major importance.

### Disclosure of Invention

It is an object of the invention to provide a reverse-conducting insulated gate transistor with reduced snapback effect, in particular at low voltages and low currents.

This object is achieved by a reverse-conducting semiconductor device according to claim 1.

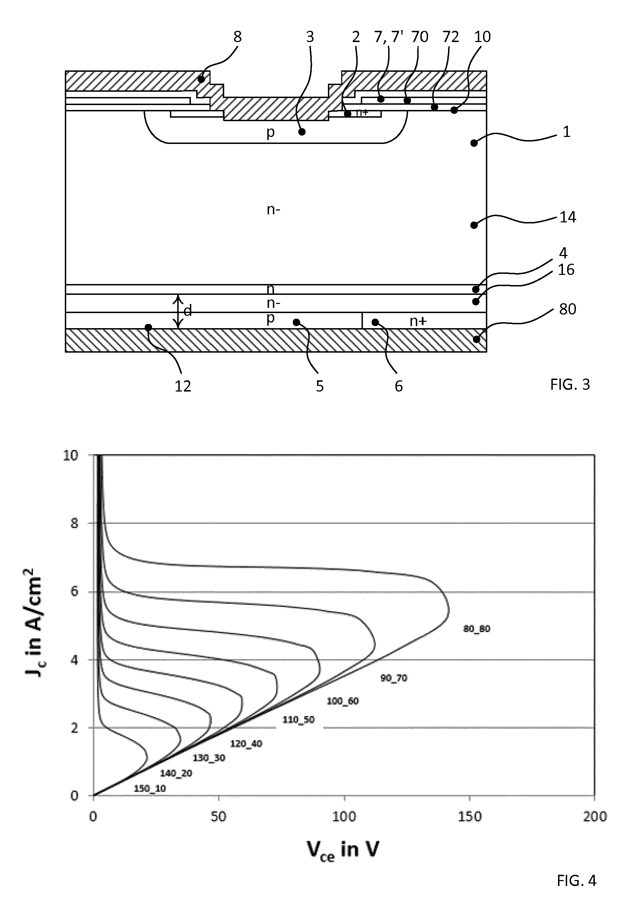

The inventive reverse-conducting insulated gate bipolar transistor (RC-IGBT) as shown in FIG 3 comprises a first main electrode on a first main side and a second main electrode on a second main side opposite to the first main side. On the first main side a gate electrode is arranged, which comprises an electrically conductive gate layer, which is insulated from any doped layer (i.e. source, base and drift layer) by an insulating layer. Doped layers are arranged in the following order from the first main side to the second main side:
- a source layer of a first conductivity type,
- a base layer of a second conductivity type different from the first conductivity type, wherein the source layer and the base layer contact the first main electrode,
- a drift layer of the first conductivity type having a low doping concentration,
- at least one anode layer of the second conductivity type alternating with
- at least one anode short layer of the first conductivity type, wherein the at least one anode layer and the at least one anode short layer contact the second main electrode.

The drift layer comprises a first drift layer section towards the first main side and a second drift layer section towards the second main side. A field stop layer is arranged between the first drift layer section and the second drift layer section and above the at least one anode layer. The field stop layer has a thickness of at most 3 µm and a maximum doping concentration, which is higher than of the drift layer.

The inventive RC-IGBT has the same blocking capability as a prior art IGBT with deep diffused n-buffer, but a strongly reduced conductivity in and around the field stop layer. The inventive deep lying field stop layer leads to a significantly weakened anode-short effect in a RC-IGBT. The second drift layer section functions as a separation layer between the field stop layer and the anode layer. Along the periphery of the anode layer the electrical properties are similar to those in a non punch-through IGBT, i.e. an IGBT having no buffer layer (which is a highly doped layer of the same conductivity type as the drift layer arranged between and adjoining (i.e. touching) the drift layer and the anode layer) leading to a strong mitigation of the anode-short effect. Carrying out the same variations of the anode layer and anode short layer stripe widths as for the conventional geometry from FIG 1 (I-V curves in FIG 2), the corresponding results for the inventive RC-IGBT are shown in FIG 4. The snapback voltage and the collector current density at snapback are reduced by a factor of about 4. Again, the widest anode layer width and the narrowest anode short stripe width yield the lowest snapback voltage (maximum of V_{CE}) and current density J_{c}.

Further preferred embodiments of the inventive subject matter are disclosed in the dependent claims.

### Brief Description of Drawings

The subject matter of the invention will be explained in more detail in the following text with reference to the attached drawings, in which:
- FIG 1: shows a cross sectional view on a prior art RC-IGBT with a planar gate electrode;
- FIG 2: shows the current density J_{C} versus the collector-emitter voltage V_{CE} for the prior art RC-IGBT of FIG 1 at 400 K;
- FIG 3: shows a cross sectional view on an inventive RC-IGBT with a planar gate electrode having a continuous field stop layer;
- FIG 4: shows the current density J_{C} versus the collector-emitter voltage V_{CE} for the inventive RC-IGBT of FIG 3 at 400 K;
- FIG 5: shows a cross sectional view on another inventive RC-IGBT with a trench gate electrode having a continuous field stop layer;
- FIG 6: shows a cross sectional view on another inventive RC-IGBT having a second drift layer section 16, which is lower doped than the first drift layer section 14;
- FIG 7: shows a cross sectional view on another inventive RC-IGBT having a field stop layer limited to the region above the at least one anode layer;
- FIG 8: shows a cross sectional view on another inventive RC-IGBT having a field stop layer limited to the region above the at least one anode layer plus a distance from a boundary line between an anode and anode short layer of at most ± 2 * d;
- FIG 9: shows a cross sectional view on another inventive RC-IGBT having a field stop layer above the at least one anode layer and terminated by a field stop interruption layer;
- FIG 10: shows a cross sectional view on another inventive RC-IGBT having a field stop layer 4 having two field stop regions 40, 42 which have a gap 44 between each other at the borderline between the anode and anode stop layer 5, 6;
- FIG 11: shows a cross sectional view on another inventive RC-IGBT having a field stop layer 4 having two field stop regions 40, 42 which have a gap 44 between each other shifted from the borderline between the anode and anode stop layer 5, 6 by at most ± 2 * d;
- FIG 12: shows the current density Jc versus the collector-emitter voltage V_{CE} for the inventive RC-IGBT of FIG 11 at 400 K;
- FIG 13: shows a cross sectional view on another inventive RC-IGBT having a field stop layer having two field stop regions which have a gap between each other, wherein the gap is filled with an field stop interruption layer having the same thickness as the field stop layer 4;
- FIG 14: shows a cross sectional view on another inventive RC-IGBT having a field stop layer having two field stop regions which have a gap between each other, wherein the gap is filled with an field stop interruption layer, which extends to the second main electrode;
- FIG 15: shows the current density Jc versus the collector-emitter voltage V_{CE} for the inventive RC-IGBT of FIG 14 at 400 K;
- FIG 16: shows a cross sectional view on another inventive RC-IGBT having a field stop layer and gap similar to FIG 14, but a buffer layer, which is limited to an area above the p anode layer; and
- FIG 17: shows the current density Jc versus the collector-emitter voltage V_{CE} for the inventive RC-IGBT of FIG 16 at 400 K;

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

In FIG 3 a first embodiment of an inventive reverse-conducting insulated gate bipolar transistor (RC-IGBT) is shown. The inventive RC-IGBT has a first main electrode 8 on a first main side 10 and a second main electrode 80 on a second main side 12 opposite to the first main side 10. On the first main side 10 a gate electrode 7 in form of a planar gate electrode 7' is arranged, which comprises an electrically conductive gate layer 70, which is insulated from any doped layer (i.e. source layer 2, base layer 3 and drift layer 1) by an insulating layer 72. For a planar gate electrode 7', the electrically insulating layer 72 is arranged on the first main side 10 on top of the drift layer 1, the base layer 3 and source layer 2. It at least partially covers the at least one source layer 2, the base layer 3 and the drift layer 1. The electrically conductive gate layer 70 is arranged on the first main side 10 electrically insulated from the at least one base layer 3, the source layer 2 and the drift layer 1 by the insulating layer 72. Exemplarily, the gate layer 70 is completely embedded into the insulating layer 72.

Exemplarily, the insulating layer 72 comprises a first electrically insulating layer, exemplarily made of a silicon dioxide, and a second electrically insulating layer, exemplarily also made of a silicon dioxide, exemplarily of the same material as the first electrically insulating layer. The second electrically insulating layer covers the first electrically insulating layer. For an RC-IGBT with a gate layer 5 formed as a planar gate electrode 5' as shown in FIG 1 the first electrically insulating layer is arranged on top of the first main side 10. In between the first and second electrically insulating layers, the gate layer 70 is embedded, exemplarily it is completely embedded. Thus, the gate layer 70 is separated from the base layer 1, the source layer 2 and the drift layer 1 by the first electrically insulating layer. The gate layer 70 is typically made of a heavily doped polysilicon or a metal like aluminum.

The at least one source layer 2, the gate layer 70 and the insulating layer 72 are formed in such a way that an opening is created above the base layer 3. The opening is surrounded by the at least one source layer 2, the gate layer 70 and the insulating layer 72.

The first main electrode 8 is arranged on the first main side 10 within the opening so that it is in direct electrical contact to the base layer 3 and the source layer 2. This first main electrode 8 exemplarily also covers the insulating layer 72, but is separated and thus electrically insulated from the gate layer 70 by the second electrically insulating layer.

From the first main side 10 to the second main side 12 layers are arranged in the following order in one common substrate: an n doped source layer 2, a p doped base layer 3, wherein the source layer 2 and the base layer 3 contact the first main electrode 8, an n- doped drift layer 1 having a low doping concentration, at least one p doped anode layer 5 alternating with at least one n doped anode short layer 6. The at least one anode layer 5 and the at least one anode short layer 6 contact the second main electrode 80. Exemplarily, Ti, Ni, Au or Al are chosen as a material for the first and/or second main electrode 8, 80.

In an exemplary embodiment, an n doped enhancement layer is arranged between the base layer 3 and the drift layer 1 for having lower on-state losses. The enhancement layer separates the base layer 3 from the drift layer 1 and it has higher doping concentration than the drift layer 1. The enhancement layer can be present in planar gate designs as well as in trench gate designs.

The n type anode short layers 6 and the p type anode layers 5 have a higher doping concentration than the doping concentration of the drift layer 1.

The anode and anode short layers 5, 6 may have any appropriate design well known to the experts in the field like a strip (rectangular) design, circular design, square design. The anode layers 5 (or anode short layers 6) may be interconnected with each other, i.e. forming a continuous layer or they may be separated from each other by other layer, i.e. the anode short layer 6.

The design of the anode and anode short layers 5, 6 may be constant over the whole device (or at least in the active cell region), so that these layers 5, 6 form a regular geometrical design, but the design may also be irregular, e.g. by the introduction of large anode layers 5, which may have a width corresponding to the drift layer thickness. In an exemplary embodiment, the anode and anode short layers 5, 6 are arranged as stripes having a width, which shall be the maximum diameter of a circle that can be completely laid into the anode or anode short layer 5, 6 in a plane parallel to the second main side 12. In an exemplary embodiment, the width of the anode layers 5 is larger than the width of the anode short layers 6. Exemplarily, the width of the anode layers 5 is at least 2 or at least 4 times larger than of the anode short layers 6.

The n type anode short layers 6 and the p type anode layers 5 can be arranged in the same plane or, alternatively, they can also be arranged in different planes, whereas the planes from the n type anode short layers 6 and the p type anode layers 5 may be spaced from each other, exemplarily at least by the thickness of that layer, which is arranged farer away from the second main side 12. Devices with such n type anode short layers 6 and p type anode layers 5 being arranged in different planes and their manufacturing methods are known from the European patent applications with filing numbers EP 07150162 and EP 07150165.

In the inventive RC-IGBT a diode is formed between the first main electrode 8, which forms an anode electrode in the diode, the base layer 3, part of which forms an anode layer of the diode, the drift layer 1, part of which forms a base layer for the diode, the n type anode short layer 6, which layer forms a cathode layer, and the second main electrode 80, which forms a cathode electrode.

In the inventive RC-IGBT an insulated gate bipolar transistor (IGBT) is formed between the first main electrode 8, which forms an emitter electrode in the IGBT, the source layer 2, which forms a source region, the base layer 3, part of which forms a channel region, the drift layer 1, part of which forms a base layer for the IGBT, the p type anode layer 5, and the second main electrode 80, which forms a collector electrode. A semiconductor device may comprise a plurality of such IGBT and diode cells on one substrate.

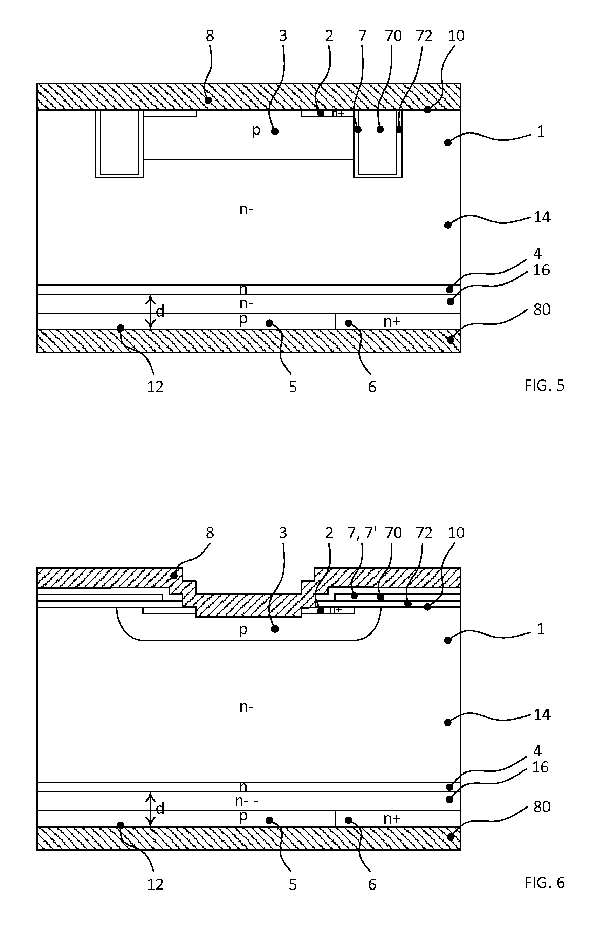

Alternatively to the inventive RC-IGBT with a planar gate electrode 7', the inventive RC-IGBT may comprise a gate electrode 7, formed as trench gate electrode 7" as shown in FIG 5. The gate layer 70 of the trench gate electrode 7" is arranged in the same plane as the base layer 3 (plane parallel to the first main side 10) and adjacent to the source layer 2, separated from each other by a first insulating layer, which also separates the gate layer 70 from the drift layer 1. A second insulating layer is arranged on top of the gate layer 70, thus insulating the gate layer 70 from the first main electrode 8. Again, the first and second insulating layer form the insulating layer 72.

Exemplarily, the drift layer 1 has a constantly low doping concentration. Therein, the substantially constant doping concentration of the drift layer 1 shall mean that the doping concentration is substantially homogeneous throughout the drift layer 1, however without excluding that fluctuations in the doping concentration within the drift layer 1 being in the order of a factor of one to five may be possibly present due to e.g. a fluctuations in the manufacturing process. The drift layer thickness and doping concentration is chosen due to the application needs and on the substrate material for the device. The inventive RC-IGBT structure can be used for Si and wide bandgap devices like SiC devices. An exemplary doping concentration of the drift layer 1 is between 1 * 10¹² cm⁻³ and 5 * 10¹⁴ cm⁻³ for a silicon device. For a wide bandgap such as silicon carbide, the drift layer 1 may have a doping concentration between 1*10¹⁴ and 1*10¹⁶ cm⁻³.

The drift layer 1 comprises a first drift layer section 14 towards the first main side 10 and a second drift layer section 16 towards the second main side 12. Between the first drift layer section 14 and the second drift layer section 16, a field stop layer 4 is arranged, i.e. sandwiched between the two drift layer sections 14, 16. The field stop layer 4 is arranged above the at least one anode layer 5 and thus, covers the at least one anode layer 5. The field stop layer 4 is a very thin layer of at most 3 µm, at most 2 µm or at most 1 µm, which may also be called a delta layer. Below the field stop layer 4 towards the second main side 12, the second drift layer section 16 is arranged, which has a thickness of at most 10 µm or at most 5 µm. A minimum thickness of the second drift layer section may be at least 0.5 µm or at least 1 µm.

The field stop layer 4 has a maximum doping concentration which is higher than the maximum doping concentration of the drift layer 1. If not stated otherwise, the maximum doping concentration may also simply be called doping concentration in this patent application. Exemplarily, the doping concentration of the field stop layer is at least 10 or at least 100 times larger than the doping concentration of the drift layer. Exemplarily, the doping concentration of the field stop layer 4 is at least 100 times higher than of the drift layer for a silicon device and at least 10 times higher for a wide bandgap device such a silicon carbide. In another exemplary embodiment, the doping concentration of the field stop layer is at most 1*10⁶ times larger than the doping concentration of the drift layer.

The doping concentration of the drift layer 1 can be constant and the same in the first drift layer section 14 and the second drift layer section 16 as described before. Alternatively, the drift layer sections 14, 16 may have different doping concentrations. Exemplarily, the doping concentration in the first drift layer section 14 is constant and the doping concentration in the second drift layer section 16 is lower than in the first drift layer section 14 (FIG 6). This may exemplarily be achieved by epitaxially growing the second drift layer section 16 or by performing a diffusion of a dopant. The low doping concentration in the second drift layer section contributes to generate increased resistance for electrons along the boundary between the anode layer 5 and anode short layer 6. The effect gets stronger for higher doping concentrations in the first drift layer section 14, which are exemplarily applied for lower voltage RC-IGBT, exemplarily from 600 V to 2.5 kV classes, and for SiC RC-IGBTs, which have about a factor of 10 to 100 higher doping concentration than comparable Si devices.

The field stop layer 4 may be a continuous layer covering the at least one anode layer 5 and the at least one anode short layer 6 with the second drift layer section 16 in between as shown in FIG 3. Thus, the field stop layer 4 completely separates the first and second drift layer section 14, 16.

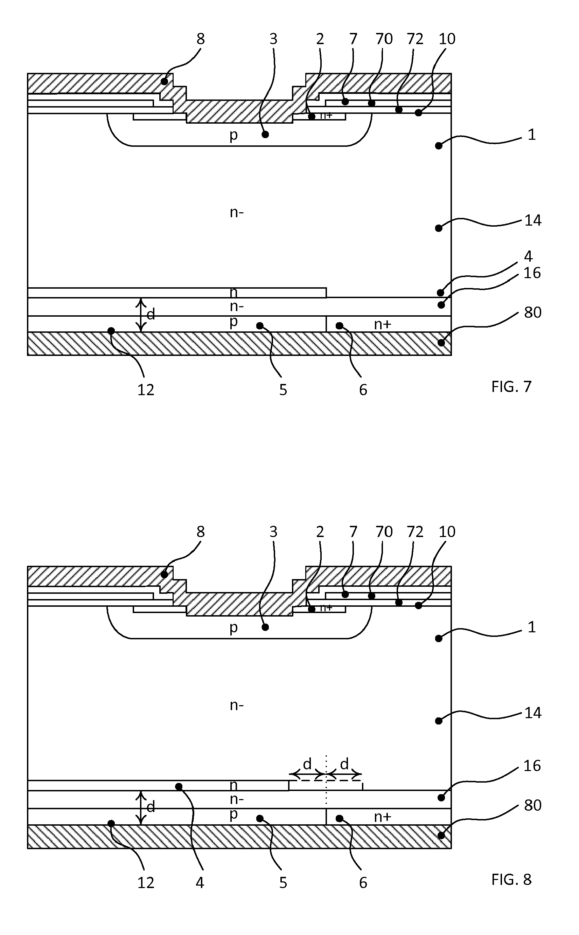

Alternatively to the field stop layer 4 being a continuous layer over the whole plane parallel to the second main side 12, the field stop layer 4 may be laterally terminated. The field stop layer 4 may be limited to the area above the at least one anode layer 5 (FIG 7). At the boundary line between at least one anode layer 5 and anode short layer 6, the field stop layer 4 may be terminated within a region having a width of ± 2 * d, wherein d is a distance between the field stop layer 4 and the second main electrode 80. Thus, close to the boundary line, the field stop layer 4 may project above the anode layers, i.e. it may extend to an area above the anode short layers 6. FIG 8 shows the lateral termination of the field stop layer 4 by the dashed line to both sides of the boundary line. Thus, the field stop layer 4 may end above the anode layer 5 (continuous line) or it may project the anode layer 5 into a region above the anode short layer 6 (dashed line).

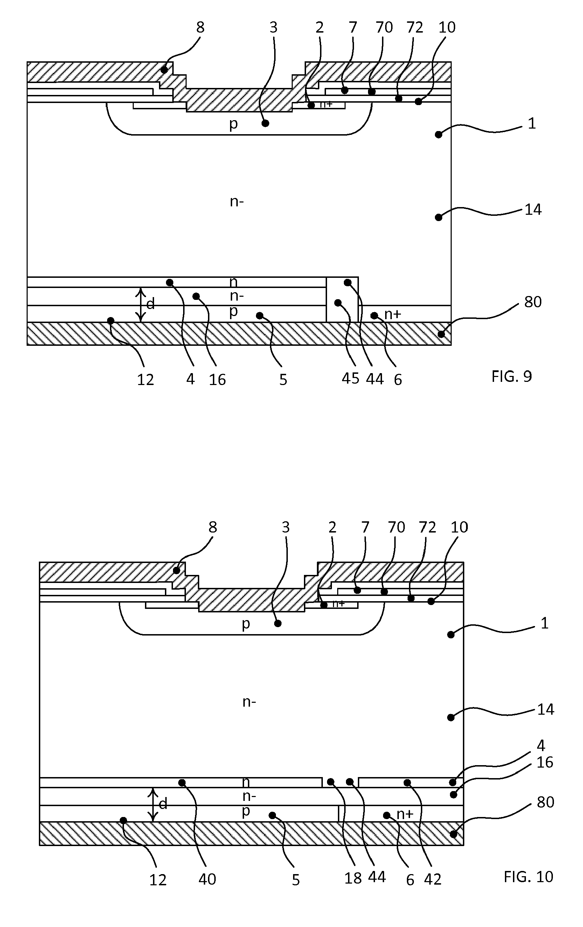

When the field stop layer 4 is terminated at or close to the boundary line, a field stop interruption layer 45 may be arranged at the termination part of the field stop layer 4. The field stop interruption layer 45 is made of an insulating material, exemplarily of silicon dioxide. The field stop interruption layer 45 may have the same thickness as the field stop layer 4, but it may also have a larger thickness. Exemplarily, the field stop interruption layer 45 may extend to the second main electrode, thereby separating the anode layers 5 and anode short layers 6 (FIG 9).

In an exemplary embodiment, the field stop layer 4 comprises at least two field stop regions 40, 42, which are separated from each other by a gap 44 having a width of at most 2 * d, exemplarily having a width of 0.1 to 0.3 times the thickness of the field stop layer 4 or exemplarily up to 0.5 µm, wherein d = is a distance from the field stop layer 4 to the second main electrode 80. The lateral resistance between the field stop regions 40, 42 is larger when a larger gap width is chosen. The gap 44 may be arranged at a lateral distance of at most ± 2 * d above a boundary line between at least one anode layer 5 and at least one anode short layer 6. The distance ± 2*d shall mean the distance, by which the field stop region 40 projects to a region above the anode layer 5 or is smaller than the region above the anode layer 5. That means that the gap 44 can be placed above the anode layer 5 or above the anode short layer 6 or right above the borderline between those two layers 5, 6.

The gap 44 leads to a strong increase in resistance in the plane of the field stop layer 4 for electrons trying to bypass the anode layer 5. By having such a gap 44, the flow of charges in lateral direction can be prohibited or substantially reduced. Thereby, the IGBT and diode part of the device can be better separated and the electric field can be stopped at the gap 44. The impact on breakdown and leakage currents is small when the gap 44 is placed above the anode short layer 6; its n-dopant profile will stop any eventual penetration of the electric field through the gap 44.

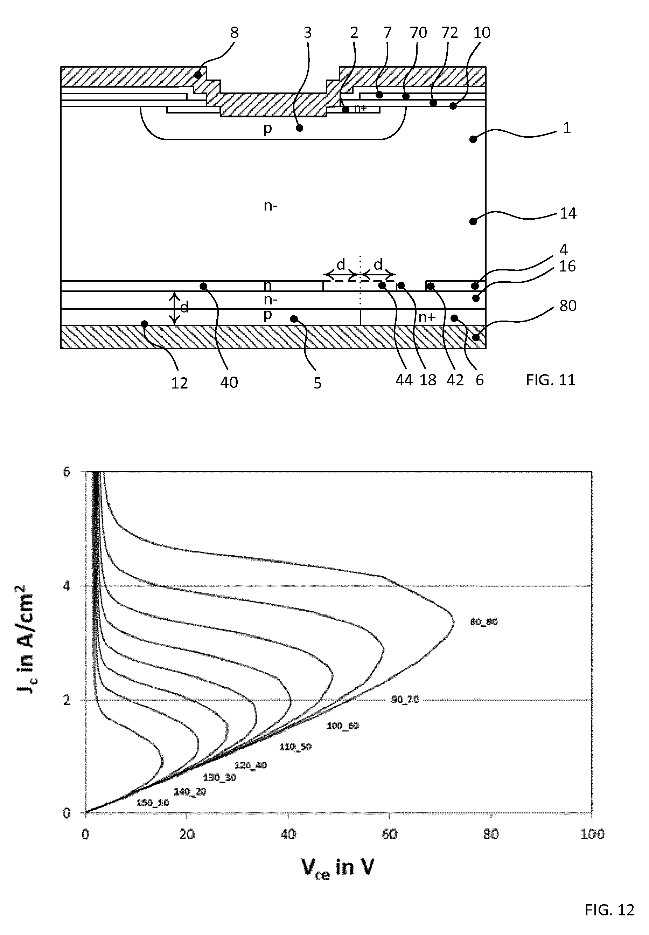

The increased resistance caused by the narrow gaps is able to further reduce the snapback voltage and the snapback current density. Compared to the reference case shown in FIG 2 for a prior art RC-IGBT, the reduction approaches a factor of 8 for a field stop layer 4 with one gap 44 above the anode short layer 6 (FIG 12). In FIG 12, the device shown in Fig 11 is used with a connection layer 18 in the gap 44.

In the gap 44, a connection layer 18 may be arranged being made of the material of the drift layer 1 and with the same doping concentration of the drift layer 1. For a drift layer 1 having different doping concentrations in the first and second drift layer sections 14, 16, the doping concentration in the connection layer 18 may be in the same range as either of the drift layer sections 14, 16. At least, the doping concentration in the connection layer 18 may exemplarily be not higher than in the drift layer 1.

It is possible to further increase the resistivity in the field stop layer plane by introducing multiple gaps. The field stop layer portion comprising the gaps 44 is exemplarily placed above the line separating anode layer 5 and anode short layer 6 or again, the field stop layer portion covering the anode layer 5 may project the anode layer 5 by at most ± 2 * d.

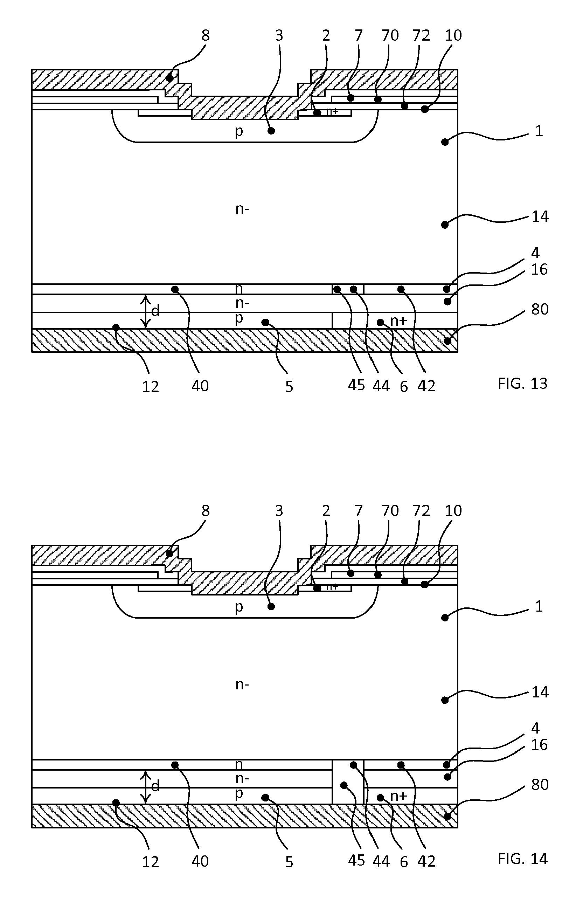

Alternatively to the connection layer 18, an electrically insulating field stop interruption layer 45 may be placed in the gap 44. As for the terminating field stop interruption layer 45 (as shown in FIG 9) the layer 45 may be made of silicon dioxide. Such a field stop interruption layer 45 results in a further increase of the resistance between the two field stop regions 40, 42. FIG 13 shows an inventive RC-IGBT structure where the thickness of the field stop interruption layer 45 is equal to the field stop layer thickness, whereas FIG 14 shoes a field stop interruption layer 45, which extends to the second main electrode 80.

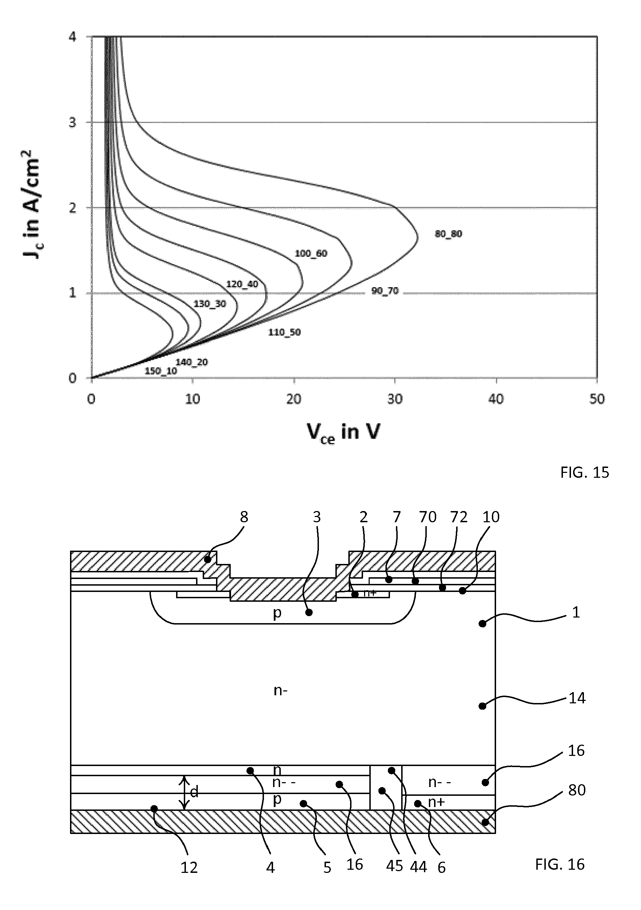

The non-conducting portion between the field stop regions has a tremendous effect on the snapback behaviour of the RC-IGBT. FIG 15 shows a set of on-state IV curves of the geometries in FIG 14 for the same variation of anode layer stripe widths as used in the examples before. Due to the field stop interruption layer 45 having a greater thickness than the field stop layer 4, exemplarily extending to the second main electrode 80, the snapback voltages and current densities are further strongly reduced as shown in FIG 15. Snapback voltages now vary from 8 to 33 V (compared to a variation from 110 to 630 V for the reference RC-IGBT with conventional, deep diffused buffer layer). This corresponds to a reduction by a factor of 15 to 20 compared to the prior art RC-IGBT devices. With the reduction of the snapback voltages, also the snapback current densities are reduced (0.5 to 1.5 A/cm2). Compared to the reference case, the reduction of snapback current densities also exceeds a factor of 10.

FIG 16 shows a combination of a lower doped second drift layer section 16 than the first drift layer section 14, a limited field stop layer 4 to a region above the at least one anode layer 5 and a field stop interruption layer 45 extending to the second main electrode 80.

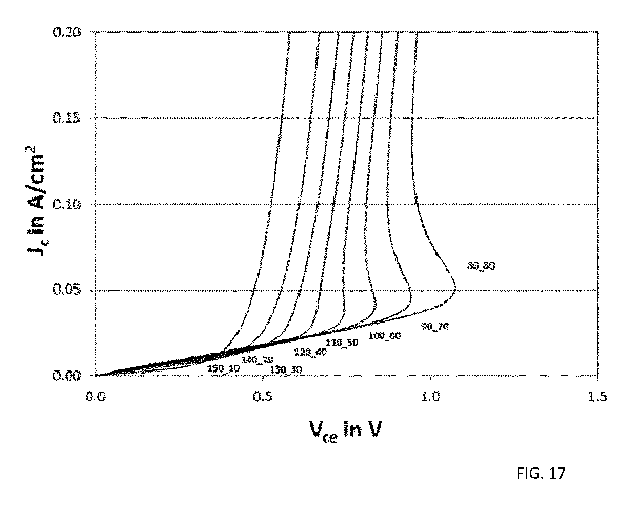

For an anode sided design with 80 mm / 80 mm width for both p anode layer stripe and n-short layer stripe, snapback voltage has been reduced to 1.1 V. This corresponds to a 500 to 600 fold reduction when compared to the prior art RC-IGBT (shown in FIG 2). The negative differential resistivity disappears when the stripe widths reach a 110 µm / 50 µm ratio. All IV curves in FIG 17 which are free of snapback show a unipolar MOSFET-like conduction at V_{CE} lower than 0.5 to 0.7 V. In fact, these structures are able to conduct current in the reverse direction, i.e., in the freewheeling diode mode. Even a 150 µm /10 µm design with minimal n-short area should yield a diode on-state of 2.12 V at 60 A/cm2 and at 400 K.

In another exemplary embodiment, the conductivity types of the layers are switched, i.e. all layers of the first conductivity type are p type (e.g. the drift layer 1 and anode short layer 6) and all layers of the second conductivity type are n type (e.g. the base layer 3 and anode layer 5).

The inventive reverse-conducting semiconductor device can for example be used in a converter.

### Reference List

- 1: drift layer
- 10: first main side
- 12: second main side
- 14: first drift layer section
- 16: second drift layer section
- 18: connection layer
- 2: source layer
- 3: base layer
- 4: field stop layer
- 40, 42: field stop region
- 44: gap
- 45: field stop interruption layer
- 48: buffer layer
- 5: anode layer
- 6: anode short layer
- 7: gate electrode
- 7': planar gate electrode
- 7": trench gate electrode
- 70: gate layer
- 72: insulating layer
- 8: first main electrode
- 80: second main electrode

## Claims

1. A reverse-conducting insulated gate bipolar transistor having a first main electrode (8) on a first main side (10) and a second main electrode (80) on a second main side (12) opposite to the first main side (10), wherein on the first main side (10) a gate electrode (7) is arranged, which comprises an electrically conductive gate layer (70), which is insulated from any doped layer by an insulating layer (72), wherein layers are arranged in the following order from the first main side (10) to the second main side (12):
a source layer (2) of a first conductivity type,
a base layer (3) of a second conductivity type different from the first conductivity type, wherein the source layer (2) and the base layer (3) contact the first main electrode (8),
a drift layer (1) of the first conductivity type having a low doping concentration, at least one anode layer (5) of the second conductivity type alternating with at least one anode short layer (6) of the first conductivity type, wherein the at least one anode layer (5) and the at least one anode short layer (6) contact the second main electrode (80),
**characterized in, that** the drift layer (1) comprises a first drift section (14) towards the first main side (10) and
a second drift section (16) towards the second main side (12),
a field stop layer (4) is arranged between the first drift section (14) and the second drift section (16) above the at least one anode layer (5), which field stop layer (4) has a thickness of at most 3 µm and a maximum doping concentration, which is higher than of the drift layer (1).

2. The reverse-conducting insulated gate bipolar transistor according to claim 1, **characterized in, that** the field stop layer (4) projects above the at least one anode layer by a distance of at most ± 2 * d, wherein d = is a distance from the field stop layer (4) to the second main electrode (80).

3. The reverse-conducting insulated gate bipolar transistor according to claim 1, **characterized in, that** the field stop layer (4) is a continuous layer covering the at least one anode short layer (6).

4. The reverse-conducting insulated gate bipolar transistor according to any of the claims 1 to 3, **characterized in, that** the field stop layer (4) has a doping concentration that is at least one of
- at least 10 or at least 100 times larger than the doping concentration of the drift layer, or
- at most 1*10⁶ times larger than the doping concentration of the drift layer.

5. The reverse-conducting insulated gate bipolar transistor according to any of the claims 1 to 4, **characterized in, that** the second drift section (16) has at least one of
- a thickness of at most 10 µm or at most 5 µm or
- . a thickness of at least 0.5 µm or at least 1 µm.

6. The reverse-conducting insulated gate bipolar transistor according to any of the claims 1 to 5, **characterized in, that** the second drift section (16) has doping concentration that is the same or lower than of the first drift section (14).

7. The reverse-conducting insulated gate bipolar transistor according to any of the claims 1 to 5, **characterized in, that** the doping concentration of the second drift section (16) is at least 5 or at least 10 times lower than of the first drift section (14).

8. The reverse-conducting insulated gate bipolar transistor according to claim 3, **characterized in, that** in a plane parallel to the second main side (12) the field stop layer (4) comprises at least two field stop regions (40, 42), each of which are separated from each other by a gap (44) having a width of at most 2 * d, wherein d = is a distance from the field stop layer (4) to the second main electrode (80).

9. The reverse-conducting insulated gate bipolar transistor according to claim 8, **characterized in, that** the at least one gap (44) is arranged at a lateral distance of at most ± 2 * d above a boundary line between at least one anode layer (5) and at least one anode short layer (6) and the at least one gap has a width of at most 2 * d, wherein d = is a distance from the field stop layer (4) to the second main electrode (80).

10. The reverse-conducting insulated gate bipolar transistor according to claim 8 or 9, **characterized in, that** in the gap (44) a connection layer (18) of the first conductivity type is arranged having a doping concentration lower or equal to the doping concentration of the drift layer (1).

11. The reverse-conducting insulated gate bipolar transistor according to claim 8 or 9, **characterized in, that** in the gap (44) a field stop interruption layer (45) is arranged, which is made of an insulating material.

12. The reverse-conducting insulated gate bipolar transistor according to claim 11, **characterized in, that** the field stop interruption layer (45) extends from the field stop layer (4) to the second main electrode (80).

13. The reverse-conducting insulated gate bipolar transistor according to claim 2, **characterized in, that** the field stop layer (4) is terminated by a field stop interruption layer (45), which is made of an insulating material.

14. The reverse-conducting insulated gate bipolar transistor according to claim 13, **characterized in, that** the field stop interruption layer (45) extends from the field stop layer (4) to the second main electrode (80).
